# EUROPÄISCHE PATENTSCHRIFT

(11) **EP 1 219 029 B1**
(45) Veröffentlichungstag und Bekanntmachung des Hinweises auf die Patenterteilung: **14.05.2003**
(21) Anmeldenummer: 00954610.2
(22) Anmeldetag: 09.08.2000
(51) Int. Cl.: H03K 17/0814

(54) **SCHALTUNGSANORDNUNG FÜR DEN ÜBERSPANNUNGSSCHUTZ EINES LEISTUNGSTRANSISTORS ZUR STEUERUNG EINER INDUKTIVEN LAST**
CIRCUIT ARRANGEMENT FOR THE OVERVOLTAGE PROTECTION OF A POWER TRANSISTOR FOR CONTROLLING AN INDUCTIVE LOAD
CIRCUIT POUR LA PROTECTION CONTRE LES SURTENSIONS D'UN TRANSISTOR DE PUISSANCE DESTINE A LA COMMANDE D'UNE CHARGE INDUCTIVE

(30) Priorität: 03.09.1999 DE 19942023
(43) Veröffentlichungstag der Anmeldung: 03.07.2002
(73) Patentinhaber: Moeller GmbH, 53115 Bonn (DE)
(72) Erfinder: MELCHERT, Wilhelm, D-53773 Hennef (DE); SCHMITZ, Gerd, D-53844 Troisdorf (DE)
(86) Internationale Anmeldenummer: EP0007715
(87) Internationale Veröffentlichungsnummer: WO01018965

(56) Entgegenhaltungen:
- EP-A- 0 331 251
- FR-A- 2 733 648

## Beschreibung

### Technisches Gebiet

Die Erfindung betrifft eine Schaltungsanordnung für den Überspannungsschutz eines Leistungstransistors zur Steuerung einer induktiven Last nach dem Oberbegriff von Anspruch 1, insbesondere zur Pulsbreitensteuerung einer induktiven Last, beispielsweise der Antriebsspule eines Magnetantriebes.

### Stand der Technik

Aus der Druckschrift EP-A2-0 331 251 ist eine Schaltungsanordnung für den Überspannungsschutz eines Leistungstransistors zur Pulsbreitensteuerung einer Motorwicklung als induktive Last bekannt. Diese Schutzschaltung enthält parallel zum Eingang eines Gleichrichters einen ersten Varistor und parallel zur Schaltstrecke des Leistungstransistors, der mit der Motorwicklung und einem Begrenzungswiderstand an den Ausgang des Gleichrichters angeschlossen ist, einen zweiten Varistor. Der erste Varistor sorgt in den Grenzen seiner thermischen Belastbarkeit für den Grobschutz der gesamten Schaltung, während der Feinschutz für den Leistungstransistor von dem zweiten Varistor besorgt wird, wobei eine vorzugsweise mit dem zweiten Varistor in Reihe liegende Parallelanordnung aus Diode und Widerstand die von dem begrenzenden zweiten Varistor verursachte Energie absorbiert. Unterhalb seiner Begrenzung fließt durch den zweiten Varistor ein merklicher Querstrom, der zum einen eine nicht unerhebliche Verlustleistung zur Folge hat und zum anderen bei bestimmten Anwendungen und Bedingungen, insbesondere bei Antriebsspulen von Magnetantrieben im Haltebetrieb keine oder zumindest nur eine erheblich eingeschränkte Pulsbreitensteuerung des Laststromes zulässt.

Zur Vermeidung eines ständigen Stromes durch einen Varistor wird gemäß Druckschrift JP-A-05 207647 eine Schaltungsanordnung für den Überspannungsschutz einer mit einer Gleichspannungsversorgung verbundenen Last vorgeschlagen, bei der parallel zur Last sowohl eine erste Reihenschaltung aus einem Varistor und der Schaltstrecke eines bipolaren Schalttransistors und als auch eine zweite Reihenschaltung aus einer Z-Diode und einem Kondensator angeordnet sind, wobei der innere Verbindungspunkt der zweiten Reihenschaltung über einen Begrenzungswiderstand mit der Steuerelektrode des Schalttransistors verbunden ist. Der Schwellenwert der versorgungsseitigen Überspannung zum Wirksamwerden der Spannungsbegrenzung hängt hier in nachteiliger Weise von dem Stromversorgungsfaktor des Schalttransistors ab und wird außerdem noch durch den Kondensator merklich verzögert. Analoge Nachteile bestehen beim Unterschreiten des Schwellenwertes.

### Darstellung der Erfindung

Der Erfindung liegt daher die Aufgabe zugrunde, einen leistungsarmen Überspannungsschutz für einen uneingeschränkt steuernden Leistungstransistor zu erreichen.

Ausgehend von einer Schaltungsanordnung der eingangs genannten Art wird die Aufgabe erfindungsgemäß durch die kennzeichnenden Merkmale des unabhängigen Anspruches gelöst, während dem abhängigen Anspruch eine vorteilhafte Ausbildung der Erfindung zu entnehmen ist.

Beim Auftreten einer hohen Überspannung an den Versorgungsanschlüssen, beispielsweise infolge Blitzeinwirkung, wird diese in üblicher Weise durch den ersten Varistor auf das Maß seiner Klemmenspannung begrenzt. Eine weitergehende Spannungsbegrenzung für den Leistungstransistor erfolgt in der Weise, dass infolge der leitend werdenden Z-Diode der Schalttransistor durchgeschaltet wird und damit die Sperrspannung für die Schaltstrecke des Leistungstransistors auf das Maß der Klemmenspannung des zweiten Varistors begrenzt wird. Die Klemmenspannung des zweiten Varistors ist sowohl erheblich kleiner als die Klemmenspannung des ersten Varistors als auch mit ausreichender Sicherheit kleiner als die maximal zulässige Sperrspannung des Leistungstransistors zu wählen. Durch den ohmschen Anteil der induktiven Last wird der Strom durch den Schalttransistor ausreichend begrenzt. Unterhalb der Durchbruchsspannung der Z-Diode infolge des gesperrten Schalttransistors tritt kein parasitärer Strom parallel zu dem steuernden Leistungstransistor auf.

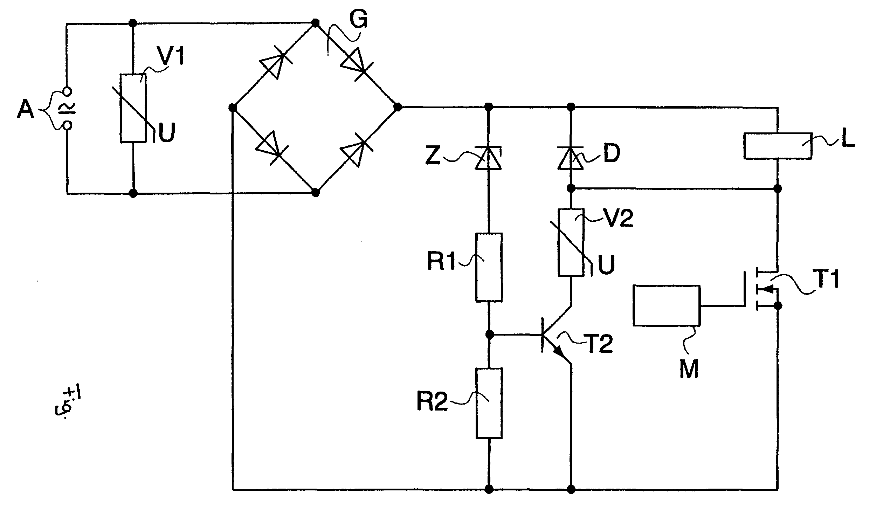

### Kurze Beschreibung der Zeichnung

Weitere Einzelheiten und Vorteile der Erfindung ergeben sich aus dem folgenden, anhand der Zeichnung erläuterten Ausführungsbeispiel. Die einzige Figur der Zeichnung zeigt im Prinzip eine erfindungsgemäße Schaltungsanordnung für den Überspannungsschutz eines Leistungstransistors zur Steuerung einer induktiven Last, die in diesem Falle die Antriebsspule eines Magnetantriebes, beispielsweise für ein elektromagnetisches Schaltgerät, ist.

### Bester Weg zur Ausführung der Erfindung

Die an Vorsorgungsanschlüssen A anliegende AC- oder DC-Versorgungsspannung wird durch einen ersten Varistor V1 auf einen relativ hohen Wert, beispielsweise 1400 V begrenzt. Die Klemmenspannung des ersten Varistors wurde relativ hoch gewählt, um diesen im zulässiger Bereich einer relativ hohen Versorgungsspannung bis zu einem maximalen Effektivwert von 625 V bei AC durch den Querstrom nicht thermisch zu überlasten. Die über die Brükken-Gleichrichteranordnung G geleitete Versorgungsspannung gelangt an die Reihenschaltung einer induktiven Last L in Form einer Antriebsspule und der Schaltstrecke eines Leistungstransistors T1, dessen Steuerelektrode von einem Pulsweitenmodulator M angesteuert wird. Die von dem ersten Varistor V1 bewirkte Spannungsbegrenzung stellt für den Leistungstransistor T1 mit einer maximalen Sperrspannung von beispielsweise 1200 V, die also unterhalb der Klemmenspannung des ersten Varistors V1 liegt, keinen wirksamen Überspannungsschutz dar. Parallel zum Ausgang der Gleichrichteranordnung G ist eine Reihenschaltung, bestehend aus einer Z-Diode Z und einem Spannungsteiler mit zwei Widerständen R1 und R2 geschaltet. Der Teilungspunkt des Spannungsteilers R1, R2 ist mit der Steuerelektrode eines Schalttransistors T2 verbunden, dessen Schaltstrecke in Reihe mit einem zweiten Varistor V2 parallel mit der Schaltstrecke des zu schützenden Leistungstransistors T1 verbunden ist. Nach Überschreiten der Durchbruchspannung der Z-Diode, beispielsweise bei 880 V, baut sich an dem Teilungspunkt des Spannungsteilers R1, R2 eine Spannung auf, die zum Durchschalten des Schalttransistors T2 führt. Damit liegt der zweite Varistor V2 über den ohmschen Widerstand, d.h. dem Wicklungswiderstand der induktiven Last L, aktiv an der Ausgangsseite der Gleichrichteranordnung G. Die Klemmenspannung des zweiten Varistors V2 mit beispielsweise mit 950 V liegt mit erheblichem Abstand unter der Klemmenspannung des ersten Varistors V1, jedoch mit ausreichender Sicherheit unter der maximal zulässigen Sperrspannung des Leistungstransistors T1. Eine Freilaufdiode D1 ist in üblicher Weise mit der induktiven Last L verbunden. Fällt die Überspannung eingangsseitig wieder unter 950 V, entfällt die Spannungsbegrenzung durch den zweiten Varistor V1, und fällt sie weiter unter 880 V, wird der Schalttransistor T2 gesperrt und der zweite Varistor V2 inaktiv, womit die normalen Betriebsbedingungen wieder hergestellt sind.

Die vorliegende Erfindung ist nicht auf die vorstehend beschriebene Ausführungsform beschränkt, sondern umfasst auch alle im Sinne der Erfindung gleichwirkenden Ausführungsformen. So lässt sich die Erfindung beispielsweise auch dahingehend abwandeln, dass bei ausschließlicher Verwendung einer DC-Versorgungsspannung die Gleichrichteranordnung G entfallen kann und somit die Versorgungsanschlüsse A direkt mit dem restlichen Teil der Schaltung verbunden sind.

## Patentansprüche

1. Schaltungsanordnung für den Überspannungsschutz eines Leistungstransistors zur Steuerung einer mit der Schaltstrecke des Leistungstransistors in Reihe liegenden induktiven Last, enthaltend
- einen die Versorgungsanschlüsse (A) überbrückenden ersten Varistor (V1) und
- einen parallel zur Schaltstrecke des Leistungstransistors (T1) angeordneten zweiten Varistor (V2),
**dadurch gekennzeichnet, dass**
- der zweite Varistor (V2) in Reihe mit der Schaltstrecke eines Schalttransistors (T2) parallel zur Schaltstrecke des Leistungstransistors (T1) angeordnet ist und
- die Reihenschaltung aus einer Z-Diode (Z) und einem ohmschen Spannungsteiler (R1, R2), dessen Teilungsspannung den Schalttransistor (T2) steuert, parallel mit der Reihenschaltung aus induktiver Last (L) und Schaltstrecke des Leistungstransistors (T1) verbunden ist.

2. Schaltungsanordnung nach Anspruch 1, **dadurch gekennzeichnet, dass** eine Gleichrichteranordnung (G) eingangsseitig mit den Versorgungsanschlüssen (A) und dem ersten Varistor (V1) und ausgangsseitig mit dem übrigen Teil der Schaltungsanordnung verbunden ist.

## Claims

1. Circuit arrangement for the overvoltage protection of a power transistor for controlling an inductive load connected in series with the switching path of the power transistor, containing
- a first varistor (V1), which bridges the supply terminals (A), and
- a second varistor (V2), which is arranged in parallel with the switching path of the power transistor (T1),
**characterized in that**
- the second varistor (V2) is arranged in series with the switching path of a switching transistor (T2) in parallel with the switching path of the power transistor (T1), and
- the series circuit comprising a zener diode (Z) and a resistive voltage divider (R1, R2), whose division voltage controls the switching transistor (T2), is connected in parallel with the series circuit comprising inductive load (L) and switching path of the power transistor (T1).

2. Circuit arrangement according to Claim 1, **characterized in that** a rectifier arrangement (G) is connected to the supply terminals (A) and to the first varistor (V1) on the input side and to the remaining part of the circuit arrangement on the output side.

## Revendications

1. Agencement de circuit pour la protection contre les surtensions d'un transistor de puissance destiné à la commande d'une charge inductive en série avec l'écartement entre les contacts du transistor de puissance, comprenant :
- une première varistance (V1) pontant les raccords d'alimentation (A) et
- une deuxième varistance (V2) disposée parallèlement à l'écartement entre les contacts du transistor de puissance (T1),
**caractérisé en ce que**
- la deuxième varistance (V2) est disposée en série avec l'écartement entre les contacts d'un transistor de commutation (T2) parallèlement à l'écartement entre les contacts du transistor de puissance (T1) et
- le montage en série constitué d'une diode zener (Z) et d'un diviseur de tension ohmique (R1, R2), dont la tension divisée commande le transistor de commutation (T2), est connecté parallèlement au montage en série constitué de la charge inductive (L) et de l'écartement entre les contacts du transistor de puissance (T1).

2. Agencement de circuit selon la revendication 1, **caractérisé en ce qu**'un agencement de redresseur (G) est connecté du côté de l'entrée aux raccords d'alimentation (A) et à la première varistance (V1) et du côté de la sortie à l'autre partie de l'agencement de circuit.
